# EUROPEAN PATENT SPECIFICATION

(11) **EP 0 426 494 B1**
(45) Date of publication and mention of the grant of the patent: **01.03.1995**
(21) Application number: 90312034.3
(22) Date of filing: 02.11.1990
(51) Int. Cl.: C23C 16/44

(54) **Vapor deposition apparatus**
Dampfablagerungsapparat
Dispositif de déposition en phase vapeur

(30) Priority: 02.11.1989 JP 286454/89
(43) Date of publication of application: 08.05.1991
(73) Proprietor: SHARP KABUSHIKI KAISHA, Osaka 545 (JP)
(72) Inventor: Mikami, Akiyoshi, Yamatotakada-shi, Nara (JP); Ogura, Takashi, Nara-shi, Nara (JP); Terada, Kousuke, Tenri-shi, Nara (JP); Yoshida, Masaru, Sango-cho, Ikoma-Gun, Nara (JP); Yamashita, Takuo, Tenri-shi, Nara (JP); Tanaka, Koichi, Nara-shi, Nara (JP); Okibayashi, Katsushi, Sakurai-shi, Nara (JP); Nakajima, Shigeo, Nara-shi, Nara (JP); Nakaya, Hiroaki, Tenri-shi, Nara (JP); Taniguchi, Kouji, Shiki-gun, Nara (JP)
(74) Representative: Brown, Kenneth Richard

(56) References cited:
- EP-A- 0 342 063
- DE-A- 3 216 465
- US-A- 3 098 763
- US-A- 3 858 548
- PATENT ABSTRACTS OF JAPAN, vol. 10, no. 117 (E-400)[2174], 2nd May 1986; & JP-A-60 253 212
- PATENT ABSTRACTS OF JAPAN, vol. 11, no. 300 (C-449)[2747], 29th September 1987; & JP-A-62 91 496
- PATENT ABSTRACTS OF JAPAN, vol. 10, no. 78 (C-335)[3135], 27th March 1986; & JP-A-60 215 594

## Description

The present invention relates to a vapor deposition apparatus.

A method for producing a semiconductor thin film for electronic devices of ZnS, GaAs, Si etc. or an insulating thin film of Ta₂O₅, Al₂O₃ etc. includes a vapor deposition method wherein starting materials of the thin film are vaporized and transferred onto a substrate. If the vapor pressure of the starting materials is low at room temperature, i.e. less than about 133.3 Nm⁻² [1 torr], the starting materials can be heated or chemically reacted with a reactive carrier gas to promote vaporization.

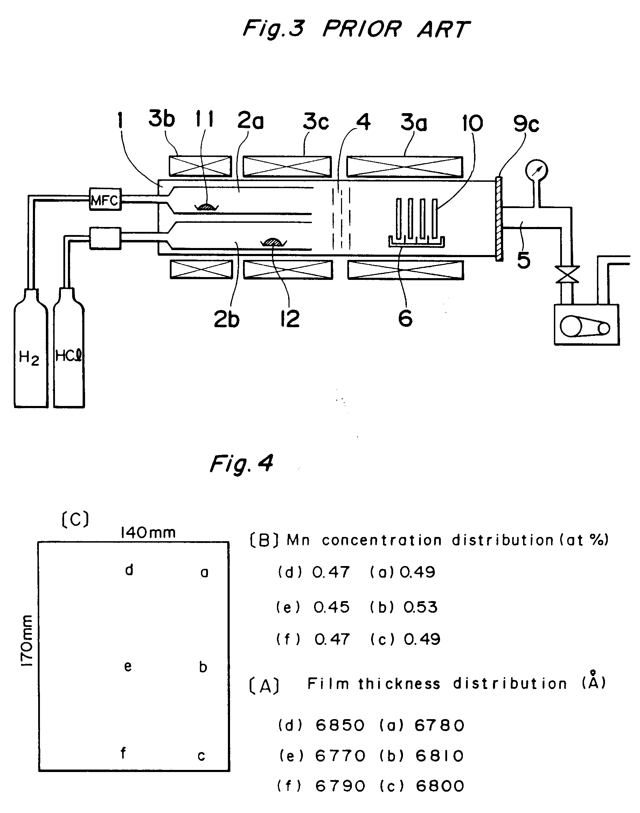

For example, if an electroluminescent (EL) film is prepared from ZnS and Mn by a heat chemical vapor deposition (CVD) method, a horizontal type vapor growth apparatus as shown in Fig. 3 is generally employed. In this apparatus, a reaction tube 1 includes two reaction tubes 2a and 2b and is surrounded with electric heaters 3a, 3b and 3c. A starting material ZnS 11 is placed in the reaction tube 2a and a metal (Mn) material 12 is placed in the reaction tube 2b. Substrates 10 are put on a holder and placed a little apart from the reaction tubes 2a and 2b. A baffle 4 for promoting the mixing of gas is arranged between the substrates 10 and the reaction tubes 2a and 2b. The electric heaters 3b and 3c heat to a desired temperature the reaction tubes 2a and 2b into which a carrier gas is introduced and starting material gas is transferred onto the substrate through the baffle 4 to form a ZnS:Mn film on the substrates 10.

JP-A-60-253212 describes a vapor growth device in which semiconductor substrates are held in parallel with the direction of current of reactive gases.

DE-A-3216495 describes apparatus for guiding gas through a horizontal tube reactor in which a substrate mounting element is rotatable within the tube reactor.

In recent years, it has been desired that the CVD film having good qualities is grown in a large area of more than 100 cm². An apparatus which can produce such high quality CVD film at low cost and in large quantities is also desired.

Three problems have existed with prior art devices as follows:
(1) As the substrates become larger and heavier, a running lift cannot be used and accumulation on a reaction tube wall attaches to the substrate.
(2) If the horizontal reaction tube is large, gas convection up and down is significant, so as to cause non-uniformity of deposited film thickness in vertically spaced substrates or in a single vertically oriented substrate.
(3) A conventional vertical apparatus for a large area substrate cannot ensure a position where solid starting materials are placed.

In accordance with the invention there is provided a vapor deposition apparatus comprising:
a horizontally fixed reaction chamber;
heating means for heating the reaction chamber;
a container disposed within said reaction chamber to define a portion thereof, said container having an inlet and an outlet formed in respective vertically spaced surface portions to direct vapor-carrying gas through the container in a direction substantially aligned with the direction of motion of the gas under convection; and
means for maintaining a substrate in said container disposed in a plane substantially aligned with the direction of motion of the gas under convection.

The present invention provides a vapor deposition apparatus which has the advantage that it can form a deposited film on a large number of substrates of large area.

In the apparatus of the present invention, gas flows in up and down directions which are the same as the direction of gas convection, and therefore effects due to gas convection are so small that the film thickness in the vertical direction and impurity concentrations are uniform.

The substrates are contained in a container which can be easily treated and protects the substrates from dust.

Figure 1 schematically shows a sectional view of a first apparatus that does not form part of the present invention.

Figure 2 schematically shows a sectional view of the apparatus of the present invention.

Figure 3 schematically shows a sectional view of a conventional apparatus.

Figure 4 shows the distribution of deposited film thickness and Mn concentration in a substrate processed in the first apparatus.

Figure 5 shows the luminance of the deposited substrate of Figure 4 as an EL panel.

### First Apparatus

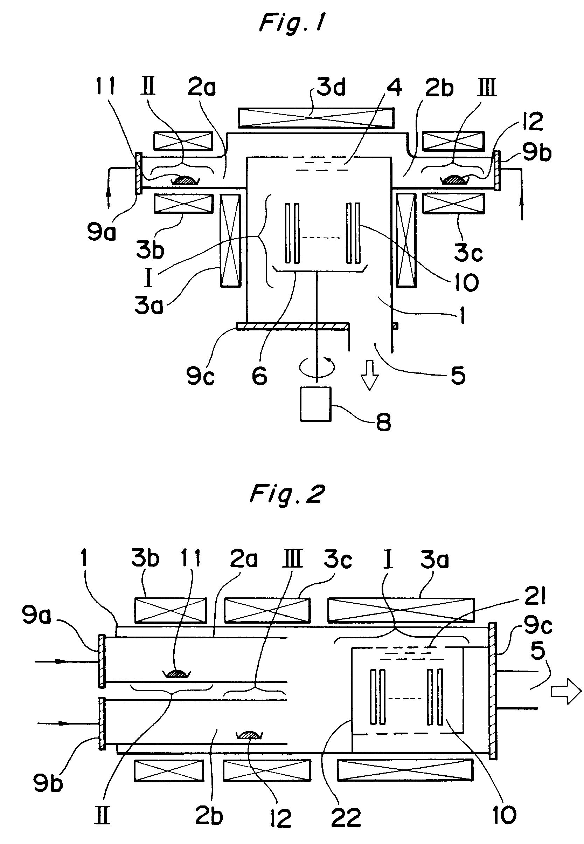

The first apparatus shown in Figure 1 does not form part of the present invention and is described merely to assist in the understanding of the apparatus of the invention shown in Figure 2.

A process will now be described in which electroluminescence film (ZnS:Mn) is formed on a large area glass substrate using an apparatus as shown in Figure 1.

In the apparatus, a main reaction tube 1 having an inside diameter of 28 cm and a height of 70 cm is vertically arranged and two branch reaction tubes 2a and 2b are horizontally connected with the upper portion of the main reaction tube 1. The main and branch reaction tubes 1, 2a and 2b are surrounded with electric furnaces 3a, 3b and 3c. Between the main reaction tube 1 and the branch reaction tube 2a and 2b, a baffle 4 is arranged and a furnace 3d is arranged thereover. An exhaust vent 5 is present at the bottom of the main reaction tube 1. A substrate holder 6 is arranged in the main reaction tube 1 and can be taken out from it. Solid starting materials are placed on solid starting material areas II and III which are present in the branch reaction tube 2a and 2b. The main reaction tube 1 and the branch reaction tubes 2a and 2b are integrally made of quartz to constitute a reaction room. The holder 6 is connected with a motor 8 and can rotate during the reaction. The substrates can be easily put in or out through the bottom of the main reaction tube. Substrates 10 are put in order at a certain space on the substrate holder 6 and placed in the main reaction tube 1 using a flange 9c for inserting and taking out the substrates 10. ZnS powder 11 and metal Mn 12 are respectively charged on quartz boards and placed in the solid starting material areas II and III using flanges 9a and 9b for inserting and taking out the solid starting material.

Two glass substrates of 6 inches size (170 X 140 mm) were piled to form one pair. Ten pairs of the glass substrates were place on the holder 6. Hydrogen gas flows in the branch reaction tube 2a which is heated to 900 to 1,000 °C, and transfers ZnS into the main reaction tube 1. Hydrogen chloride gas flows in the branch reaction tube 2b which is heated to 800 to 900 °C, and transfers Mn into the main reaction tube 1. The main reaction tube 1 was evacuated by a mechanical pump and an oil rotating pump to keep at 60 mm torr. The growing rate of the deposited film was adjusted to 0.083 to 0.333 nm. s⁻¹ [50 to 200 A/min] by controlling a flow rate of hydrogen gas, and a concentration of Mn was adjusted to 0.3 to 0.6 at % by controlling a ratio of flow rate of hydrogen gas and hydrogen chloride gas.

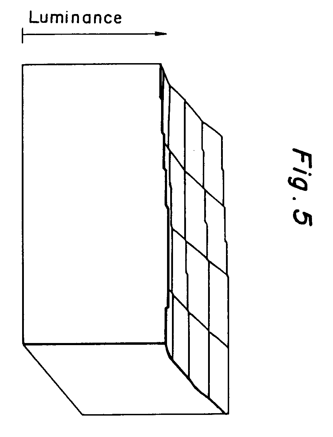

The deposited ZnS:Mn film was tested to evaluate the distribution of film thickness and Mn concentration in the same substrate and the results are shown in Fig. 4 (A), (B) and (C). The film thickness measured by a surface roughness meter had a distribution within 2% and therefore was very uniform. The Mn concentration increased approaching the periphery of the substrate and had a distribution of ±10%. The evaluation was also made between the substrates to find very small distribution. The deposited substrate was employed as an EL panel and its luminance at the surface was measured and found to be very uniform, as shown in Figure 5. Practically, the luminance distribution of MIN/Max in the surface needs to be 70% or more, and the obtained EL display meets this requirement. Even if 50 substrates were employed, sufficient uniformity was obtained. In a conventional horizontal vapor deposition apparatus, the Mn concentration distribution and film thickness distribution exhibited non-uniformity in up and down directions. Also, the luminance distribution showed unsymmetrical surface distribution in up and down directions, but such unsymmetrical distribution is not apparent in substrates produced by the first apparatus.

The solid starting materials (ZnS and Mn) should be supplied after each cycle, but a supplement can be easily supplied via the flanges 9a and 9b. Although the reaction tube has a complicated shape, no problems in strength are present and the apparatus exhibits very good quality even after 100 cycles.

In the first apparatus, since the starting material areas are separated from each other, a furnace temperature can be separately controlled.

### Second Apparatus

The apparatus of the invention will now be described with reference to Figure 2 of the drawings.

An electroluminescence film (ZnS:Mn) is formed on a large area glass substrate using an apparatus as shown in Figure 2.

The apparatus comprises a main reaction tube 1 which is horizontally arranged, and two branch reaction tubes 2a and 2b horizontally connected with the main reaction tube 1. Around the reaction tube 1, three furnaces 3a, 3b and 3c are arranged, and a substrate area I consists of a quartz substrate container 22 of which the top and bottom surface have pores 21 therein. Substrates 10 are contained in the container 22 and transferred within container 22. As gas is exhausted through an air vent 5, the starting material gas flows vertically near the substrates 10.

By using the above apparatus, a deposited film (ZnS:Mn) was prepared on the substrates such that the film was uniformly formed on a large number of substrates.

The apparatus of the invention is suitable for forming films of ZnS:Mn ZnS:Tb, ZnS:Sm, CaS:Eu, SrS:Ce or a III-V group compound (GaAs) and Si, an impurity doping thereto. The apparatus of the present invention can be useful for producing a large area thin film in large quantities.

## Claims

1. A vapor deposition apparatus comprising:
a horizontally fixed reaction chamber (1);
heating means (3a,3b,3c) for heating the reaction chamber (1);
a container (22) disposed within said reaction chamber (1) to define a portion thereof, said container (22) having an inlet and an outlet formed in respective vertically spaced surface portions to direct vapor-carrying gas through the container (22) in a direction substantially aligned with the direction of motion of the gas under convection; and
means for maintaining a substrate (10) in said container (22) disposed in a plane substantially aligned with the direction of motion of the gas under convection.

2. A vapor deposition apparatus according to claim 1 wherein said reaction chamber (1) includes a vent (5) for exhausting gas from the outlet of said container (22).

3. A vapor deposition apparatus according to claim 1 or claim 2 wherein first (2a) and second (2b) horizontally disposed branch reaction tubes each communicate at one end thereof with the interior of the reaction chamber (1) and each said branch reaction tube (2a,2b) has a gas inlet at its other end.

4. A vapor deposition apparatus according to claim 2 wherein said reaction chamber (1) is a horizontally fixed main reaction tube provided with said gas vent (5) at one end thereof, and wherein said branch reaction tubes are connected to the other end of said main reaction tube (1).

5. A vapor deposition apparatus according to any preceding claim wherein said means for maintaining comprises a holder for mounting said substrates (10) in spaced apart relationship.

6. A vapor deposition apparatus according to any preceding claim wherein said heating means (3a,3b,3c) are electric furnaces surrounding said reaction chamber (1).

7. A vapor deposition apparatus according to any preceding claim wherein the inlet and outlet of the container (22) each comprise a plurality of pores (21).

8. A vapor deposition process using a vapor deposition apparatus according to claim 3 when dependent on claim 2, or any claim when dependent thereon, wherein solid starting materials (11,12) are placed in said two branch reaction tubes (2a,2b), and carrier gas is introduced into said branch reaction tubes (2a,2b) from said gas inlets and exhausted from said gas vent (5) at a certain temperature distribution while depositing a thin film on said substrates (10).

## Patentansprüche

1. Dampfniederschlagungsapparat mit:
- einer horizontal fixierten Reaktionskammer (1);
- einer Heizeinrichtung (3a, 3b, 3c) zum Beheizen der Reaktionskammer (1);
- einem innerhalb der Reaktionskammer (1) angeordneten Behälter (22), um einen Teil derselben festzulegen, der einen Einlaß und einen Auslaß aufweist, die jeweils in vertikal voneinander beabstandeten Oberflächenbereichen ausgebildet sind, um Dampf beförderndes Gas in einer Richtung, die im wesentlichen mit der Bewegungsrichtung des Gases bei Konvektion ausgerichtet ist, durch den Behälter (22) zu führen; und
- einer Einrichtung zum Festhalten eines Substrats (10) im Behälter (22), angeordnet in einer Ebene, die im wesentlichen mit der Bewegungsrichtung des Gases unter Konvektion ausgerichtet ist.

2. Dampfniederschlagungsapparat nach Anspruch 1, bei dem die Reaktionskammer (1) eine Belüftungsöffnung (5) zum Ausblasen von Gas aus dem Auslaß des Behälters (22) aufweist.

3. Dampfniederschlagungsapparat nach Anspruch 1 oder Anspruch 2, bei dem das erste (2a) und zweite (2b) horizontal angeordnete Zweigreaktionsrohr jeweils an einem ihrer Enden mit dem Inneren der Reaktionskammer (1) in Verbindung stehen und jedes Zweigreaktionsrohr (2a, 2b) an seinem anderen Ende einen Gaseinlaß aufweist.

4. Dampfniederschlagungsapparat nach Anspruch 2, bei dem die Reaktionskammer (1) ein horizontal fixierten Hauptreaktionsrohr ist, das an einem seiner Enden mit einer Gasbelüftungsöffnung (5) versehen ist, wobei die Zweigreaktionsrohre mit dem anderen Ende des Haupreaktionsrohrs (1) verbunden sind.

5. Dampfniederschlagungsapparat nach einem der vorstehenden Ansprüche, bei dem die Einrichtung zum Festhalten einen Halter zum Montieren der Substrate (10) in voneinander beabstandeter Beziehung aufweist.

6. Dampfniederschlagungsapparat nach einem der vorstehenden Ansprüche, bei dem die Heizeinrichtung (3a, 3b, 3c) durch elektrische Öfen gebildet wird, die die Reaktionskammer (1) umgeben.

7. Dampfniederschlagungsapparat nach einem der vorstehenden Ansprüche, bei dem der Einlaß und der Auslaß des Behälters (22) jeweils eine Anzahl Poren (21) enthalten.

8. Dampfniederschlagungsverfahren unter Verwendung eines Dampfniederschlagungsapparats nach Anspruch 3 in Abhängigkeit von Anspruch 2 oder nach einem beliebigen Anspruch, wenn davon abhängig, bei dem feste Ausgangsmaterialien (11, 12) in den zwei Zweigreaktionsrohren (2a, 2b) angeordnet werden und Trägergas mit einer bestimmten Temperaturverteilung von den Gaseinlässen in die Zweigreaktionsrohre (2a, 2b) eingelassen wird und aus der Gasbelüftungsöffnung (5) ausgeblasen wird, während ein dünner Film auf den Substraten (10) abgeschieden wird.

## Revendications

1. Dispositif de dépôt en phase gazeuse comprenant :
une chambre réactionnelle fixée horizontalement (1),
des moyens de chauffage (3a, 3b, 3c) pour chauffer la chambre réactionnelle (1),
un récipient (22) disposé à l'intérieur de ladite chambre réactionnelle (1) pour définir une partie de celle-ci, ledit récipient (22) comportant une entrée et une sortie formées dans des parties de surface respectives espacées verticalement pour diriger un gaz porteur de gazeuse à travers le récipient (22) dans une direction sensiblement alignée avec la direction de déplacement du gaz sous convection, et
des moyens de maintien d'un substrat (10) dans ledit récipient (22), disposé dans un plan sensiblement aligné avec la direction de déplacement du gaz sous convection.

2. Dispositif de dépôt en phase gazeuse selon la revendication 1, dans lequel ladite chambre réactionnelle (1) comprend un évent (5) pour évacuer le gaz provenant de la sortie dudit récipient (22).

3. Dispositif de dépôt en phase gazeuse selon la revendication 1 ou 2, dans lequel le premier (2a) et le deuxième (2b) tubes réactionnels d'embranchement disposés horizontalement communiquent chacun par l'une de leurs extrémités avec l'intérieur de la chambre réactionnelle (1), chaque tube réactionnel d' embranchement (2a, 2b) ayant une entrée de gaz à son autre extrémité.

4. Dispositif de dépôt en phase gazeuse selon la revendication 2, dans lequel ladite chambre réactionnelle (1) est un tube réactionnel principal fixé horizontalement et pourvu dudit évent (5) à l'une de ses extrémités, et dans lequel lesdits tubes réactionnels d'embranchement sont connectés à l'autre extrémité dudit tube réactionnel principal (1).

5. Dispositif de dépôt en phase gazeuse selon l'une quelconque des revendications précédentes, dans lequel lesdits moyens de maintien comprennent un support pour monter lesdits substrats (10) avec un espacement mutuel.

6. Dispositif de dépôt en phase gazeuse selon l'une quelconque des revendications précédentes, dans lequel lesdits moyens de chauffage (3a, 3b, 3c) sont des fours électriques entourant ladite chambre réactionnelle (1).

7. Dispositif de dépôt en phase gazeuse selon l'une quelconque des revendications précédentes, dans lequel l'entrée et la sortie du récipient (22) comprennent chacune une série de pores (21).

8. Procédé de dépôt en phase gazeuse mettant en oeuvre un dispositif de dépôt en phase gazeuse selon la revendication 3 dans la mesure où elle dépend de la revendication 2 ou selon l'une quelconque des revendications dans la mesure où elle dépend de celle-ci, dans lequel des matériaux de départ solides (11, 12) sont placés dans lesdits tubes réactionnels d'embranchement (2a, 2b) et un gaz véhiculaire est introduit dans lesdits tubes réactionnels d'embranchement (2a, 2b) par lesdites entrées de gaz et s'échappe par ledit évent (5) avec une certaine distribution de température tout en déposant un film mince sur lesdits substrats (10).
